# EUROPÄISCHE PATENTSCHRIFT

(11) **EP 3 482 611 B1**
(45) Veröffentlichungstag und Bekanntmachung des Hinweises auf die Patenterteilung: **01.04.2020**
(21) Anmeldenummer: 17728999.8
(22) Anmeldetag: 05.05.2017
(51) Int. Cl.: H05K 7/14, H05K 9/00

(54) **ANORDNUNG UND VERFAHREN ZUR MASSEANBINDUNG EINER LEITERKARTE AN EIN GEHÄUSE EINES ELEKTRISCHEN GERÄTES**
ARRANGEMENT AND METHOD FOR ESTABLISHING A GROUND CONNECTION BETWEEN A CIRCUIT CARD AND A HOUSING OF AN ELECTRICAL DEVICE
SYSTÈME ET PROCÉDÉ DE CONNEXION À LA MASSE D'UNE CARTE DE CIRCUIT IMPRIMÉ SUR UN BOÎTIER D'UN APPAREIL ÉLECTRIQUE

(30) Priorität: 08.07.2016 DE 102016112571
(43) Veröffentlichungstag der Anmeldung: 15.05.2019
(73) Patentinhaber: Harting Electric GmbH & Co. KG, 32339 Espelkamp (DE)
(72) Erfinder: KLANKE, Volker, 32351 Stemwede (DE); WULF, Christine, 31603 Diepenau (DE); DÖDING, Peter, 32312 Lübbecke (DE); LOESCH, Andreas, 40625 Düsseldorf (DE)
(86) Internationale Anmeldenummer: PCT/DE2017/100386
(87) Internationale Veröffentlichungsnummer: WO 2018/006892

(56) Entgegenhaltungen:
- DE-A1-102011 080 170
- FR-A1- 2 557 756
- US-A- 4 855 873
- US-A1- 2004 034 994
- US-A1- 2009 020 312
- US-A1- 2014 211 432

## Beschreibung

Die Erfindung geht in einem ersten Aspekt aus von einer Anordnung zur Masseanbindung einer Leiterkarte an ein Gehäuse eines elektrischen Gerätes nach dem Oberbegriff des unabhängigen Anspruchs 1.

Die Erfindung geht in einem zweiten Aspekt aus von einem Verfahren zur Masseanbindung der Leiterkarte das zumindest teilweise elektrisch leitfähiges Gehäuse des elektrischen Gerätes mittels einer Anordnung gemäß dem unabhängigen Anspruch 1.

Derartige Anordnungen und Verfahren zur werden benötigt, um innerhalb elektrischer Geräte Störströme und damit verbundene Störfelder zu vermeiden oder diese zumindest zu verringern.

### Stand der Technik

Im Stand der Technik sind vielfältige Masseanbindungen von Leiterkarten an elektrisch leitfähige Gehäuse dazugehöriger elektrischer Geräte bekannt, wie zum Beispiel in US 2009/020312 oder US 2004/034994.

Beispielsweise ist die Kontaktierung eines Masseanschlusses einer Leiterkarte an einem Gehäuse durch eine Schraube aus der Druckschrift DE 90 10 251 U1 bekannt.

Die Druckschrift DE 10 2004 029 820 A1 schlägt ein Steuergerät vor, das ein Gehäuse aufweist, das wiederum aus einem Gehäusedeckel mit metallischen Einsätzen und einem Gehäuseboden besteht. Die metallischen Einsätze sind zur Verschraubung des Gehäusebodens einer im Gehäuse befindlichen elektrische Bauelemente aufweisenden Leiterkarte und des Gehäusedeckels vorgesehen. Die Verschraubung führt zu einem elektrischen Kontakt zwischen Gehäuseboden und der Leiterkarte und garantiert die funktionssichere Übertragung der Beschleunigungssignale vom Gehäuseboden zu Beschleunigungssensoren auf der Leiterkarte.

Die Druckschrift DE 198 33 248 C2 offenbart eine Vorrichtung zum Führen und Massekontaktieren der seitlichen Ränder einer Leiterkarte, die in ein die elektrische Masse bildendes Gerätechassis eingesetzt ist. Dabei sind an einer Blechplatte, die den seitlichen Rändern der eingesetzten Leiterkarte benachbart und unmittelbar Verbindungsteil des Gerätechassis ist, mindestens zwei gegenüberliegende Blechausprägungen vorgesehen, die zwischen sich eine Führungsnut für den Leiterkartenrand bilden. Zwischen den Blechausprägungen ist eine Massefeder eingesetzt, die in unmittelbarem galvanischen Kontakt mit der Blechplatte steht und über Federschenkel an der Massekaschierung der Leiterkarte federnd anliegt.

Die Druckschrift DE 43 26 442 A1 offenbart einen Abstandshalter zur Fixierung einer zwischen zwei Wänden eines Gehäuses angeordneten Leiterkarte. Der Abstandshalter weist eine Schulter auf, bis zu der er lagesicher in einen Durchbruch der Leiterkarte eindrückbar ist. Er steht beidseits über die Leiterkarte vor und liegt mit einem Kopf an der einen Wand und mit einem Fuß an der anderen Wand des Gehäuses an.

Die Druckschrift US 2015/0064943 A1 offenbart eine Befestigungsstruktur zur Verwendung mit einer eigenständigen Steuereinheit. Die Steuereinheit umfasst einen Gewindeeinsatz, welcher in einem umschlossenen Hohlraum angeordnet ist, welcher es ermöglicht, dass Schrauben zur Erdung einer EMI/RFI-Leiterkarte verwendet werden, in Verbindung mit der Bildung einer gedichteten und umschlossenen Tasche. Die Befestigungsstruktur ermöglicht die Erdung zu einer Metallblechgrundplatte ohne einen Leckagepfad zu der Außenseite der Steuereinheit zu bilden. Dieser Ansatz der Erdung verkapselt die Schraube, um die Bildung eines Leckagepfades zu verhindern.

Die Druckschrift DE 102 05 816 A1 schlägt ein Gehäuse für ein elektrisches Gerät mit mindestens einer im Gehäuse anordbaren elektronischen Schaltung auf einer Leiterkarte vor. Dabei ist mindestens eine im Gehäuse gehaltene Wand vorhanden, mit der nach dem Zusammenfügen der Gehäuseteile eine nahezu störstrahlungssichere Kammer gebildet ist und die mit dem Masseanschluss der Leiterkarte kontaktiert ist. An der Wand ist mindestens eine Kontaktfeder, vorzugsweise eine Schraubenfeder, befestigt, die mit ihrem einen federnden Ende, die bei der Montage des Geräts auf einer mit Masse verbundenen Kontaktfläche der Leiterkarte und/oder des Gehäuses zu liegen kommt.

Die aus dem vorgenannten Stand der Technik bekannten Federkontakte und insbesondere auf die Leiterkarte aufgelötete Federkontakte haben den Nachteil, dass sie auf der Leiterkarte wertvollen Platz in Anspruch nehmen. Weiterhin ist auch die Kontaktierung eines solchen Federkontaktes mit der Gegenseite, in diesem Fall der zweiten Gehäuseseite, unsicher und problematisch. Gegebenenfalls entsteht auf dem Federkontakt eine harte Eloxalschicht, die entfernt werden muss. Außerdem ist die entsprechende Bearbeitung und somit die Herstellung entsprechender Geräte sehr aufwendig.

Andererseits besteht bei vielen Anwendungen ein hoher Bedarf an einem entsprechenden Längenausgleich bei gleichzeitiger Massekontaktierung. Bei der serienmäßigen Herstellung elektrischer Geräte existiert beispielsweise ein erhebliches Problem, wenn der Abstand einer Leiterkarte, welche beispielsweise die Isolierkörper der Steckverbinder des elektrischen Geräts beinhaltet, zu einer benachbarten Gehäuseseite, nämlich einer Geräteanschlussseite, im Rahmen der üblichen Gehäusetoleranzen von Gerät zu Gerät variiert. Dadurch wird insbesondere die Masseanbindung der Leiterkarte an die Geräteanschlussseite erheblich erschwert, was zur Entstehung von Störfeldern führt.

Diese Variation des Abstandes kann beispielsweise dadurch zustande kommen, dass die Position der besagten Leiterkarte relativ zu einer Gerätebasisseite, welche der Geräteanschlussseite des Gehäuses parallel gegenüberliegt, bauartbedingt fest vorgegeben ist. Durch eine Aufsummierung der Toleranzen einzelner Bauteile des Gehäuses kann somit der Abstand der Leiterkarte zur Geräteanschlussseite fertigungstechnisch von Gerät zu Gerät beispielsweise bis zu 1 mm variieren.

Selbstverständlich ist es möglich und im Stand der Technik allgemein bekannt, die Masseanbindung in Form einer Verkabelung, beispielsweise über ein an die Geräteanschlussseite geschraubtes Erdungskabel, zu realisieren, um so einen entsprechenden Toleranzausgleich und die notwendige Flexibilität in Bezug auf eine freie Wahl des Anschlusspunktes am Gehäuse und insbesondere an der Geräteanschlussseite oder nahe daran zu gewährleisten. Doch ist dies zum einen bei der Herstellung mit einem unerwünscht hohen händischen Aufwand verbunden und zum anderen können auch die durch das unkontrolliert verlaufende Erdungskabel fließenden Störströme ihrerseits schädliche und insbesondere schwer vorhersagbare und nicht reproduzierbare Störfelder verursachen.

In einer weiteren suboptimalen Variante könnte auf eine Masseanbindung der Leiterkarte über die Gerätebasisseite ausgewichen werden, was jedoch eine Erhöhung des Laufwegs gehäuseinterner Störströme und somit eine Erhöhung der geräteinternen Störfelder zur Folge hat. Dies wiederum wirkt sich jedoch sehr schädlich auf die geräteinterne Signalintegrität aus, was dazu führen kann, dass solche Gerätetypen nicht mehr störungsfrei funktionieren oder dass zumindest der störungsfreie Betrieb solcher Geräte nicht mehr gewährleistet werden kann und diese Geräte somit z.B. keine Freigabe erhalten.

### Aufgabenstellung

Die Aufgabe der Erfindung besteht darin, die vorgenannten Probleme zu überwinden und eine kostengünstige und in der Herstellung unaufwändige Vorrichtung sowie ein entsprechendes Verfahren anzugeben, die dazu geeignet sind, in elektrischen Geräten derartige Störfelder zu vermeiden oder zumindest erheblich zu verringern.

Diese Aufgabe wird durch die Merkmale der unabhängigen Ansprüche gelöst.

Die Anordnung zur Masseanbindung einer Leiterkarte an ein Gehäuse eines elektrischen Gerätes umfasst
- das Gehäuse, das zumindest teilweise aus einem elektrisch leitfähigen Material besteht,
- die Leiterkarte, die zumindest einen Massekontakt aufweist, und mindestens eine Masseverbindung zur elektrisch leitenden Verbindung des mindestens einen Massekontaktes der Leiterkarte mit dem Gehäuse, wobei die mindestens eine Masseverbindung jeweils durch eine Steckverbindung variabler Einstecktiefe gebildet ist,
   wobei die Steckverbindung ein erstes Verbindungsteil und ein zweites Verbindungsteil umfasst, die zur gegenseitigen elektrischen Kontaktierung kraftschlüssig, aber innerhalb eines vorgegebenen Bereichs verschiebbar miteinander verbindbar sind,
   wobei das erste Verbindungsteil an einem Ende einen Basisbereich und gegenüberliegend einen Steckbereich besitzt, wobei der Basisbereich an dem mindestens einen Massekontakt der Leiterkarte angeordnet und elektrisch leitend damit verbunden ist,
   wobei die Leiterkarte an ihrem mindestens einen Massekontakt eine Durchgangsöffnung aufweist, durch welche das erste Verbindungsteil basisseitig an einem Stabilisierungselement mechanisch fixierbar, insbesondere verschraubbar, ist, wobei es sich bei dem Stabilisierungselement um mehrere miteinander verschraubte Schraubbolzen handelt und dass mindestens zwei dieser Schraubbolzen miteinander durch mindestens eine weitere Durchgangsöffnung eines gefalteten Bereichs der Leiterkarte und/oder mindestens einer weiteren Leiterkarte verschraubt sind, um den gefalteten Bereich und/oder die weitere Leiterkarte mechanisch zu fixieren.

Das Verfahren zur Masseanbindung einer Leiterkarte an ein zumindest teilweise elektrisch leitfähiges Gehäuse des elektrischen Gerätes mittels der vorgenannten Vorrichtung weist folgende Schritte auf:
a.) Befestigen des mindestens einen Stabilisierungselements mit seinem ersten Ende an einer Gerätebasisseite des Gehäuses;
b.) mechanisches Verbinden des mindestens einen Stabilisierungselementes an seinem zweiten Ende mit der Leiterkarte;
c.) Befestigen des mindestens einen ersten Verbindungsteils an dem mindestens einen Stabilisierungselement unter gleichzeitiger Fixierung der Leiterkarte zwischen dem mindestens einen ersten Verbindungsteil und dem mindestens einen Stabilisierungselement bei gleichzeitiger elektrischer Kontaktierung des mindestens einen Massekontakts der Leiterkarte durch das mindestens eine erste Verbindungsteil;
d.) Befestigen des mindestens einen zweiten Verbindungsteils an einer Geräteanschlussseite des Gehäuses;
e.) mechanisches Zusammenbauen des Gehäuses und gleichzeitiges automatisches elektrisch leitendes Verbinden des Gehäuses mit dem mindestens einen Massekontakt der Leiterkarte über mindestens eine Steckverbindung variabler Einstecktiefe zwischen dem mindestens einen ersten und dem mindestens einen zweiten Verbindungsteil, bei gleichzeitigem mechanischen Ausgleich innerhalb eines vorgegebenen Toleranzbereichs abweichender Gehäuseabmessungen durch eine entsprechende Anpassung der Einstecktiefe der Steckverbindung zwischen dem mindestens einen ersten und dem mindestens einen zweiten Verbindungsteil.

Vorteilhafte Ausgestaltungen der Erfindung sind in den Unteransprüchen angegeben.

Bei der Erfindung handelt es sich um eine Vorrichtung und ein Verfahren, die dazu dienen, zumindest einen Massekontakt zumindest einer Leiterkarte und insbesondere einer gefalteten Leiterkarte und/oder einer Leiterkarte, die zu einer Anordnung mehrerer Leiterkarten gehört, derart an ein elektrisch leitfähiges Gehäuse eines elektrischen Gerätes anzuschließen, dass innerhalb des Gehäuses möglichst wenig elektrische und/oder magnetische und/oder elektromagnetische Störfelder auftreten. Dabei handelt es sich bevorzugt um ein Gehäuse, das zumindest vier, bevorzugt sechs Gehäuseseiten aufweist, welche sich im Wesentlichen paarweise parallel gegenüberstehen. Insbesondere stehen sich dabei die Geräteanschlussseite und die Gerätebasisseite parallel gegenüber. Unter einer gefalteten Leiterkarte ist dabei und im Folgenden eine Leiterkarte zu verstehen, die zumindest einen gefalteten Bereich aufweist.

Ein besonders großer Vorteil der Erfindung besteht somit darin, dass auch relativ große elektrische Störungen, die beispielsweise auf einer Versorgungsleitung in Form von Spannungsspitzen, bedingt z.B. durch Ein- und Ausschaltvorgänge, entstehen, innerhalb des Gehäuses des daran angeschlossenen elektrischen Gerätes nur vergleichbar geringe Störfelder verursachen, da sie geometrisch sehr nahe an Ihrer, z.B. über elektronische Filter der Leiterkarte durchgeführte Separierung von der Nutzspannung auf die Gerätemasse geleitet werden. Dies wird dadurch ermöglicht, dass an einer solchen geeigneten Stelle zumindest eine elektrisch leitende Masseverbindung zwischen der Leiterkarte und dem Gehäuse durch eine Steckverbindung variabler Einstecktiefe gegeben ist.

Dadurch können nämlich bei der Herstellung des Gerätes durch variierende Gehäuseabmessungen unvermeidlich entstehende geometrische Abweichungen innerhalb eines vorgegebenen Toleranzbereichs ausgeglichen werden und die Masseanbindung kann an der Geräteanschlussseite stattfinden, an der bevorzugt auch der Masseanschluss des Gehäuses angeordnet ist. Dieser Masseanschluss des Gehäuses kann beispielsweise als Bestandteil des Stromanschlusses oder als eine separate Masseverbindung, z.B. in Form einer Erdungsschraube ausgestaltet sein.

Bevorzugt existiert eine Vielzahl derartiger Masseanbindungen zwischen der Leiterkarte und der Geräteanschlussseite, wobei diese Masseanbindungen möglichst homogen über die Leiterkarte und somit auch über die Geräteanschlussseite verteilt sein können. Dies gestattet in jedem Fall eine nahezu optimale Reduzierung der Wegstrecke, welche eine an einer beliebigen Stelle auf der Leiterkarte entstehende elektrische Störung, z.B. eine Spannungsspitze sowie der damit verbundene elektrische Strom, über die Gehäusemasse zurücklegen muss, bis sie über den Masseanschluss vom Gehäuse abgeleitet wird. Gleichzeitig ist eine weitgehend automatisierte serienmäßige Herstellung entsprechender Geräte möglich.

Die Erfindung ist somit, allgemein formuliert, von besonderem Vorteil, für elektrische Geräte, in deren Gehäuse eine Leiterkarte in einem vorgegebenen Abstand zu einer ersten Gehäuseseite angeordnet ist und gleichzeitig mit einer zweiten Gehäuseseite, welche der ersten Gehäuseseite parallel gegenüberliegt, in einen elektrischen Massekontakt gebracht werden soll.

Die Erfindung hat weiterhin den Vorteil, dass sich der Herstellungsaufwand solcher Geräte verringert, da die Massekontaktierung, auch bei einer Vielzahl solcher Masseverbindungen, beim mechanischen Zusammenbau des Gehäuses automatisch stattfindet.

Bei der Leiterkarte kann es sich insbesondere um eine gefaltete Leiterkarte handeln. Unter einer gefalteten Leiterkarte ist eine Leiterkarte zu verstehen, die zumindest einen gefalteten Bereich aufweist. Dieser gefaltete Bereich kann zumindest einen Teilbereich, insbesondere einen unteren Teilbereich, umfassen, welcher in seiner Funktion und Anordnung einer in einer anderen Ausgestaltung vorgesehenen weiteren Leiterkarte entspricht.

So können, beispielsweise auf dem unteren Teilbereich einer gefalteten Leiterkarte besonders leistungsintensive Bauteile angeordnet sein. Dieser untere Teilbereich kann dann sehr dicht, beispielsweise in einem Abstand d < 1 mm, zu der Gerätebasisseite, also einer im üblichen Einsatz typischerweise unten angeordneten Gehäuseseite, angeordnet sein, was eine sehr gute Wärmeableitung über das Gehäuse ermöglicht, die zudem noch durch dazwischen angeordnete Wärmeleitelemente unterstützt wird.

Insbesondere handelt es sich bei dem Stabilisierungselement um mehrere aneinander verschraubte Schraubbolzen, von denen insbesondere derjenige Schraubbolzen, der in der Gerätebasisseite angebracht ist, kürzer ist als die anderen Schraubbolzen. Dadurch kann es ermöglicht werden, dass der gefaltete Bereich der Leiterkarte, insbesondere mit seinem unteren Teilbereich, oder die besagte weitere Leiterkarte sehr nahe an der Gerätebasisseite angeordnet ist. Beispielsweise kann ihr Abstand zur Gerätebasisseite auf diese Weise weniger als 2 mm, also z.B. 1 mm betragen. Dadurch ist eine sehr gute Wärmeableitung darauf angeordneter, insbesondere besonders leistungsintensiver elektronischer Bauteile gegeben, insbesondere, wenn zusätzlich Wärmeleitelemente auf der Gerätebasisseite angeordnet sind.

Ein oberer Teilbereich der gefalteten Leiterkarte kann dazu parallel ausgerichtet an der gegenüberliegenden Gehäuseseite, nämlich der Geräteanschlussseite, angeordnet sein. Beide Teilbereiche können über ein oder bevorzugt mehrere insbesondere mehrteilige Stabilisierungselemente an der Gerätebasisseite fixiert sein. Der obere Teilbereich der gefalteten Leiterkarte kann den Stromanschluss und z.B. ein Netzteil, insbesondere ein Schaltnetzteil sowie dazugehörige elektrische Eingangsfilter aufweisen, wobei die Eingangsfilter dafür vorgesehen sind, besonders hochfrequente Störströme aus der Versorgungsspannung herauszufiltern und üblicherweise auf die Gehäusemasse abzuleiten. Das Netzteil kann aber auch an einem seitlichen Bereich der gefalteten Leiterkarte, insbesondere nahe dem Masseanschluss, angeordnet sein.

Weiterhin kann die gefaltete Leiterkarte in ihrem oberen Teilbereich Isolierkörper weiterer Steckverbinder, beispielsweise M12-Buchsen, aufweisen. Diese sind im eingebauten Zustand in die Geräteanschlussseite des Gehäuses integriert, insbesondere in dazugehörige Hülsen, beispielsweise Einschraubhülsen, wobei die Isolierkörper im zusammengebauten Zustand des Gerätes in die jeweilige Hülse eintauchen, wobei die Eintauchtiefe im Rahmen der besagten Gehäusetoleranzen variabel ist.

Dies gilt selbstverständlich nicht nur für die hier beispielhaft angeführte gefaltete Leiterkarte mit ihren Teilflächen sondern genauso auch auf Anordnungen mit mehreren gestapelten, d.h. in einem vorgegebenen Abstand parallel zueinander angeordneten Leiterkarten, die beispielsweise über das Stabilisierungselement an der Gerätebasisseite fixiert sind. Insbesondere kann es sich dabei auch um eine Vielzahl gestapelter Leiterkarten handeln. Weiterhin kann es sich auch um eine gefaltete Leiterkarte in Kombination mit einer oder mehreren gestapelten weiteren Leiterkarten handeln.

Eine der Leiterkarten kann beispielsweise den Stromanschluss und die Isolierkörper aufweisen und entspricht so dem oberen Teil der gefalteten Leiterkarte.

Die Verwendung einer gefalteten Leiterkarte hat jedoch gegenüber der Verwendung zweier paralleler Leiterkarten den Vorteil, dass ggf. keine elektrische Verbindungseinrichtung zwischen den beiden Leiterkarten benötigt wird, denn und dass und statt dessen ein ebenfalls mit elektronischen Bauteilen bestückbarer Verbindungsbereich, nämlich der seitliche Bereich, existiert.

Das Stabilisierungselement kann aus mehreren Teilen, insbesondere Schraubbolzen, bestehen, die beispielsweise durch Durchgangsbohrungen der weiteren Leiterkarten und/oder der Teilbereiche der gefalteten Leiterkarte aneinander fixiert, insbesondere mit dazugehörigen Gewindestiften und hohlzylindrischen Gewindeausnehmungen aneinander verschraubt, sind. Auf diese Weise können die weiteren Leiterkarten und/oder der gefaltete Bereich der Leiterkarte in einem vorgegebenen Abstand zueinander an dem Stabilisierungselement fixiert sein. Auch können die weiteren Leiterkarten und/oder der gefaltete Bereich der Leiterkarte auf diese Weise je nach Bedarf an dafür vorgesehenen weiteren Massekontakten elektrisch leitend über das mindestens eine Stabilisierungselement und die Steckverbindung mit der Geräteanschlussseite verbunden sein; sie können aber an dem mindestens einen Stabilisierungselement auch lediglich mechanisch fixiert sein. Insbesondere kann so durch eine Vielzahl von Stabilisierungselementen, Masseanschlüssen und Verbindungsteilen auch das Prinzip einer "vermaschten Erdung" umgesetzt werden, bei dem sich jede Störung, unabhängig vom Ort ihrer Entstehung, automatisch ihren kürzesten Weg zum Nullpotential sucht. Dieses Prinzip hat den Vorteil, dass es universell einsetzbar ist, d.h. unabhängig vom jeweiligen Schaltungsdesign der Leiterkarte und unabhängig von der geometrischen Entstehung der jeweiligen Störung nahezu optimal funktioniert.

Aus diesem Grund sieht eine vorteilhafte Ausgestaltung vor, dass in der Leiterkarte, z.B. in dem oberen Teilbereich der gefalteten Leiterkarte oder in der besagten (obersten, d.h. der Geräteanschlussseite benachbarten) Leiterkarte der gestapelten Anordnung, mindestens 3, insbesondere mindestens 4, insbesondere mindestens 6, insbesondere mindestens 8, insbesondere mindestens 9, insbesondere mindestens 12 oder mehr Massekontakte mit Durchgangsbohrungen vorgesehen sind, durch die jeweils ein erstens Verbindungsteil über jeweils einem Stabilisierungselement an der Gerätebasisseite fixiert ist. Insbesondere können diese Massekontakte möglichst homogen auf der Leiterkartenoberfläche verteilt sein, um das Prinzip der vermaschten Erdung möglichst vorteilhaft umzusetzen.

Der Stromanschluss des elektrischen Gerätes ist vorteilhafterweise in die Geräteanschlussseite integriert und kann sowohl für die Stromversorgung des Netzteils als auch für die Erdung des Gehäuses zuständig sein.

Alternativ oder ergänzend kann ein separater Masseanschluss, z.B. in Form einer Masseanschlussschraube, am Gehäuse angebracht sein. Dann ist es besonders vorteilhaft, die Erdungsschraube in der Nähe des Stromanschlusses und insbesondere auch in der Nähe des Netzteils anzuordnen, also entweder an der Geräteanschlussseite in der Nähe des Stromanschlusses oder auch an einem Seitenteil in der Nähe der Geräteanschlussseite und insbesondere in der Nähe des Stromanschlusses. Im letzteren Fall ist es selbstverständlich vorteilhaft, wenn die Geräteanschlussseite zusammen mit dem Seitenteil und insbesondere mehreren, bevorzugt allen Seitenteilen einstückig verbunden ist, also z.B. ein Oberteil bildet, dass beim Zusammenbauen des Gerätes auf die Gerätebasisseite aufgesetzt und befestigt, z.B. verschraubt, wird.

Vorteilhafterweise ist das Stabilisierungselement an der Gerätebasisseite des Gehäuses befestigt und dass das zweite Verbindungsteil ist an der Geräteanschlussseite des Gehäuses elektrisch leitend befestigt, wobei die Geräteanschlussseite der Gerätebasisseite im zusammengebauten Zustand parallel gegenüberliegt. Dies vereinfacht die Montage eines solchen Geräts erheblich, da z.B. beim Aufstecken der Geräteanschlussseite auf das weitere Gehäuse oder Aufsetzen des Gehäuseoberteils auf die Gerätebasisseite so automatisch die insbesondere vermaschte Masseanbindung der Elektronik des Gerätes an dessen Gehäuse erfolgt.

Vorteilhafterweise können das erste Verbindungsteil und das zweite Verbindungsteil zur elektrischen Kontaktierung form- und kraftschlüssig miteinander verbindbar und dadurch elektrisch miteinander kontaktierbar sein.

In einer vorteilhaften Ausgestaltung kann eines der mindestens beiden Verbindungsteile, bevorzugt das erste Verbindungsteil, einen Basisbereich und gegenüberliegend einen Steckbereich besitzen. Sein Basisbereich ist dann an dem Massekontakt der Leiterkarte angeordnet und elektrisch leitend damit verbunden. Der Basisbereich kann einen Gewindestift oder ein Innengewinde aufweisen. Steckseitig kann das erste Verbindungsteil bevorzugt buchsenförmig ausgestaltet sein. Beispielsweise kann es eine Ausnehmung aufweisen, die zumindest bereichsweise hohlzylindrisch ausgeführt ist und in einer bevorzugten Ausgestaltung steckseitig einen trichterförmigen Einlassbereich besitzt. Weiterhin kann das Verbindungsteil steckseitig in Steckrichtung verlaufende Schlitze aufweisen. Beispielsweise kann es sich bei dem ersten Verbindungsteil um einen Tulpenstehbolzen handeln.

Das zweite Verbindungsteil kann ebenfalls eine Steck- und eine Basis besitzen. Gegenüber dem bevorzugt buchsenförmigen ersten Verbindungsteil kann das zweite Verbindungsteil steckseitig die Funktion eines Pinkontaktes erfüllen und kann seinerseits basisseitig an der zweiten Gehäuseseite befestigt und elektrisch leitend damit verbunden sein.

In einer alternativen Ausgestaltung könnte auch das erste Verbindungsteil steckseitig einen Pinkontakt darstellen und das zweite Verbindungsteil könnte demgegenüber die Funktion eines Buchsenkontaktes übernehmen.

Somit kann also entweder das erste Verbindungsteil an seinem Steckbereich buchsenförmig ausgestaltet sein und das zweite Verbindungsteil dem ersten Verbindungsteil gegenüber die Funktion eines Pinkontaktes erfüllen, oder dass das zweite Verbindungsteil kann an seinem Steckbereich buchsenförmig ausgestaltet sein und dass das erste Verbindungsteil dem zweiten Verbindungsteil gegenüber die Funktion eines Pinkontaktes erfüllen.

Vorteilhafterweise ist zumindest eines der beiden Verbindungselemente zumindest steckseitig elastisch verformbar. So kann es sich bei einem der beiden Verbindungselemente um einen Tulpenstehbolzen handeln und/oder es kann sich bei einem der beiden Verbindungselemente um einen Spannstift oder eine Spannhülse handeln.

Insbesondere ist zumindest eines der beiden Verbindungselemente senkrecht zur Steckrichtung, d.h. in radialer Richtung, elastisch verformbar. Beispielsweise kann es sich bei dem buchsenförmige Verbindungsteil um einen Tulpenstehbolzen handeln, der sich dadurch auszeichnet, dass er im Bereich seiner im wesentlichen hohlzylindrischen Ausnehmung steckseitig beginnende und in basisseitiger Richtung verlaufende Schlitze aufweist, wodurch in seinem Steckbereich federnde Laschen zur kraftschlüssigen Aufnahme und elektrischen Kontaktierung des Pinkontaktes gebildet sind.

Es kann aber alternativ oder ergänzend auch der Pinkontakt in radialer Richtung verformbar sein. Der Pinkontakt kann dazu z.B. in Form einer Spannhülse, eines Spannstiftes oder einer Spiralhülse ausgeführt sein. Beispielsweise kann es sich um einen Hohlzylinder aus federblech mit einem axialen Schlitz handeln, wodurch der Pinkontakt radial verformbar ist. Es kann sich aber auch einen im Querschnitt spiralfederartigen Pinkontakt aus Federstahl handeln.

Vorteilhafterweise besitzt das erste Verbindungsteil an einem Ende einen Basisbereich und gegenüberliegend einen Steckbereich, wobei der Basisbereich an dem mindestens einen Massekontakt der Leiterkarte angeordnet und elektrisch leitend damit verbunden ist.

Die Leiterkarte kann an ihrem mindestens einen Massekontakt eine Durchgangsöffnung aufweisen, durch welche das erste Verbindungsteil basisseitig an dem Stabilisierungselement mechanisch fixierbar, insbesondere verschraubbar, ist. Dazu kann das erste Verbindungsteil an seinem Basisbereich vorteilhafterweise einen Gewindestift aufweisen, der durch die Durchgangsöffnung geführt wird um an einer hohlzylindrischen Gewindeausnehmung eines zum Stabilisierungselement gehörenden Schraubbolzens verschraubt zu werden. Alternativ kann auch der Schraubbolzen an dieser Stelle einen Gewindestift aufweisen, der durch die Durchgangsöffnung der Leiterkarte geführt und mit einer hohlzylindrischen Gewindeausnehmung des ersten Verbindungsteils verschraubt wird.

Insbesondere kann es sich es sich bei dem Stabilisierungselement um mehrere miteinander verschraubte Schraubbolzen handeln, wobei mindestens zwei dieser Schraubbolzen miteinander durch mindestens eine weitere Durchgangsöffnung eines gefalteten Bereichs der Leiterkarte und/oder mindestens einer weiteren Leiterkarate verschraubt sind, um den gefalteten Bereich und/oder die weitere Leiterkarte mechanisch zu fixieren. Dabei kann der gefaltete Bereich der Leiterkarte und/oder die mindestens eine weitere Leiterkarte an zumindest einer der besagten weiteren Durchgangsöffnungen einen weiteren Massekontakt aufweisen, um zusätzlich zur besagten mechanischen Fixierung auch eine weitere Massekontaktierung über das Stabilisierungselement und die Steckverbindung zu gestatten.

In einer bevorzugten Ausgestaltung weist das Gehäuse zur Befestigung jedes Stabilisierungselements und jedes zweiten Verbindungsteils in seiner Gerätebasisseite und in der Geräteanschlussseite jeweils eine zylinderförmige Ausnehmung auf. Insbesondere können zumindest diejenigen Ausnehmungen, die in der Gerätebasisseite angeordnet sind, jeweils ein Innengewinde aufweisen, um einen Gewindestift des jeweiligen Stabilisierungselements darin einzuschrauben. Diejenigen Ausnehmungen, die in der Geräteanschlussseite angeordnet sind, können ebenfalls zum Einschrauben des zweiten Verbindungsteils, beispielsweise einem Tulpenstehbolzen oder der Basisseite eines Kontaktstiftes, ein Innengewinde aufweisen. Es kann sich aber auch um hohlzylindrische Ausnehmungen ohne Innengewinde handeln, die beispielsweise dafür vorgesehen sind, einen Spannstift oder eine Spannhülse kraftschlüssig aufzunehmen.

### Ausführungsbeispiel

Ein Ausführungsbeispiel der Erfindung ist in den Zeichnungen dargestellt und wird im Folgenden näher erläutert. Es zeigen:
- Fig. 1a: Ein Gehäuse mit zwei Leiterkarten und einem Stabilisierungselement in einer ersten Ausführungsform;
- Fig. 1b: das Gehäuse mit einer gefalteten Leiterkarte und dem Stabilisierungselement;
- Fig. 2a: das Gehäuse mit drei Leiterkarten und einem modifizierten Stabilisierungselement;
- Fig. 2b: das Gehäuse mit einer gefalteten und einer weiteren Leiterkarte und dem modifizierten Stabilisierungselement;
- Fig. 3 a,: b eine Steckverbindung aus zwei Verbindungsteilen im ungesteckten und im gesteckten Zustand;

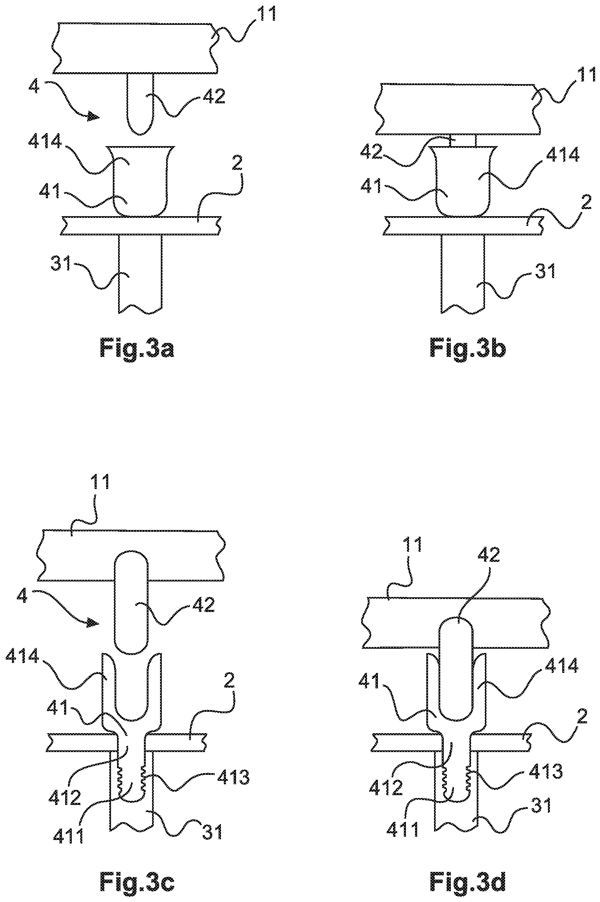

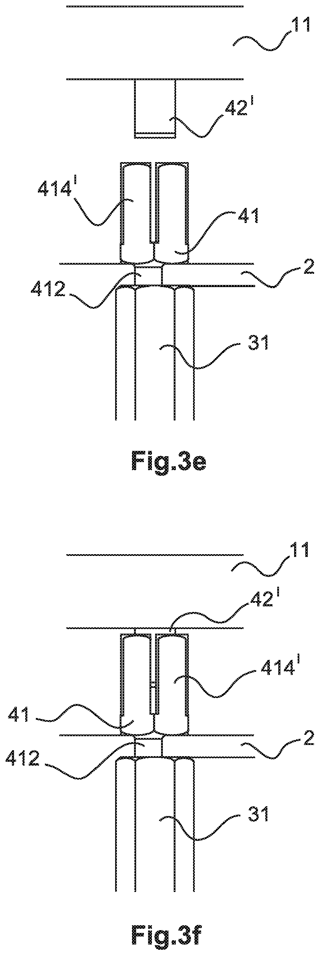

- Fig. 3 c, d: die vorgenannte Steckverbindung im Querschnitt durch die Verbindungsteile;
- Fig. 3 e, f: die Steckverbindung mit einem Tulpenstehbolzen als erstem Verbindungsteil;

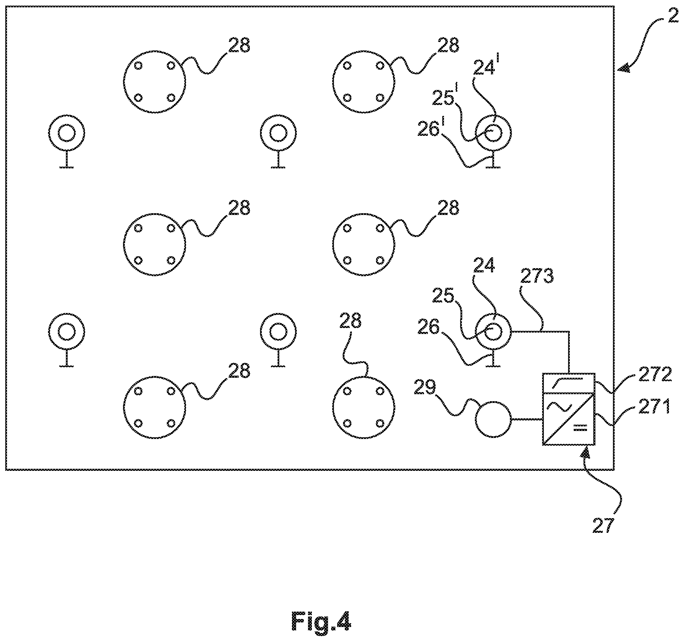

- Fig. 4: die Leiterkarte mit Durchgangsöffnungen und daran angeordneten Massekontakten;

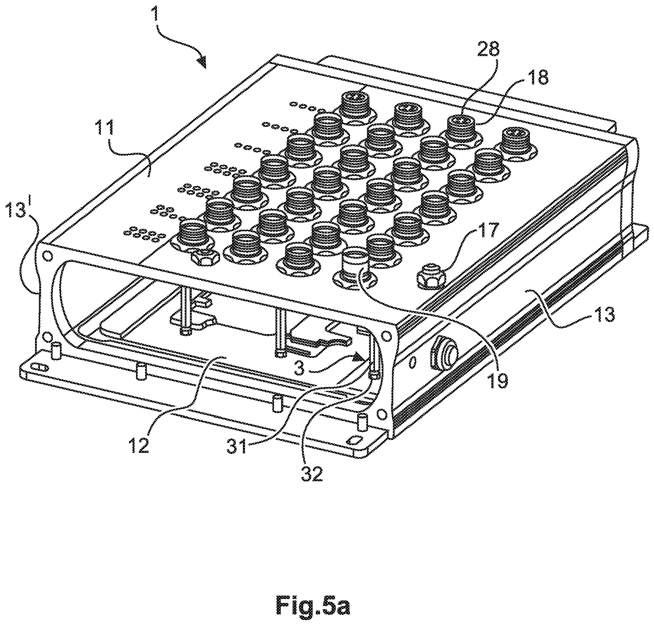

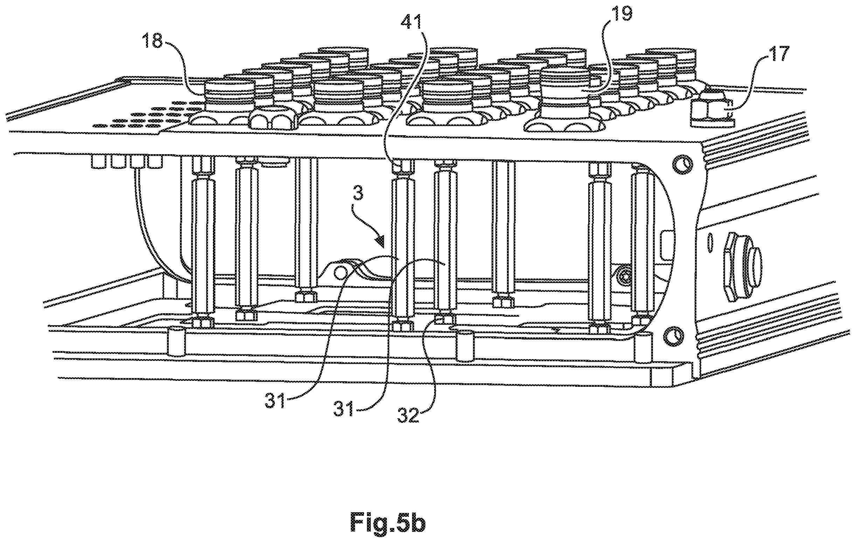

- Fig. 5 a, b: ein Gehäuse in einer zweiten Ausführungsform in einer schrägen Draufsicht und mit Einblick in eine Frontseitenöffnung;

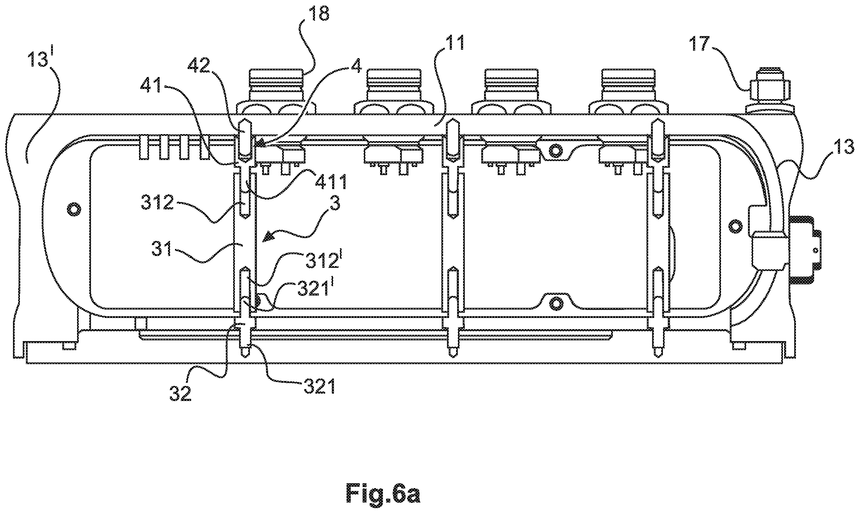

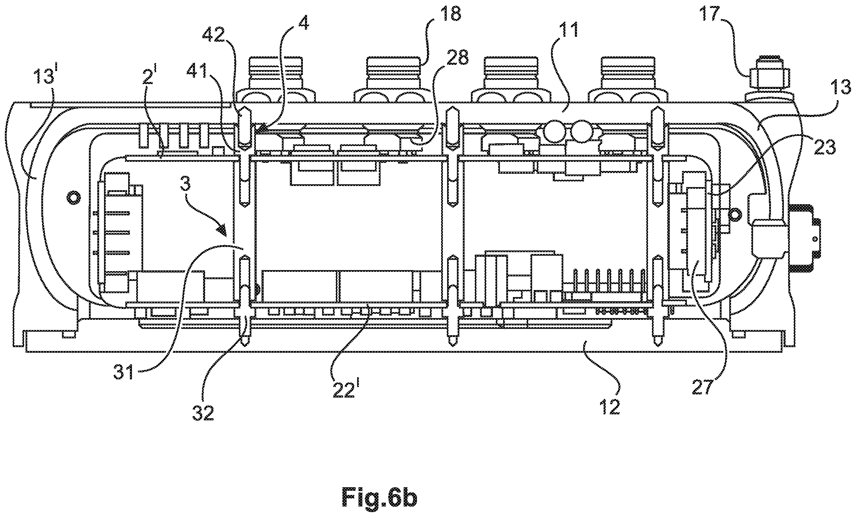

- Fig. 6 a, b: das Gehäuse im Querschnitt durch die Verbindungsteile ohne und mit zwei bestückten Leiterkarten.

Die Figuren enthalten teilweise vereinfachte, schematische Darstellungen. Zum Verbindungsteil werden für gleiche, aber gegebenenfalls nicht identische Elemente identische Bezugszeichen verwendet. Verschiedene Ansichten gleicher Elemente könnten unterschiedlich skaliert sein.

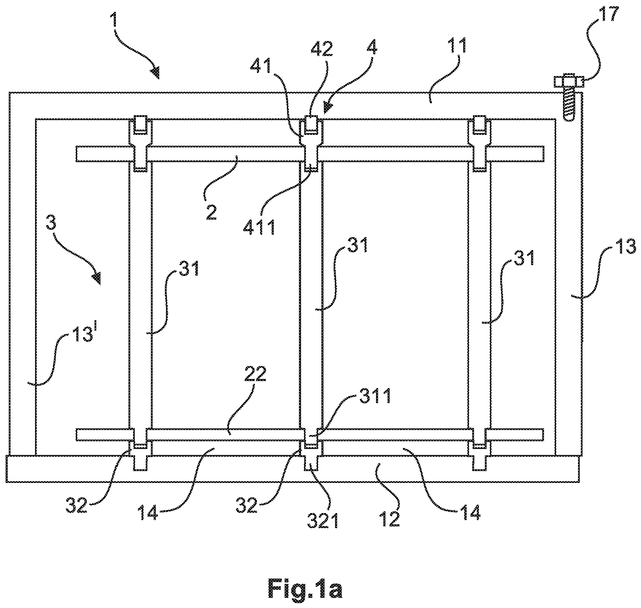

Die Fig. 1a zeigt eine schematische Darstellung eines Gehäuses 1 mit einer Gerätebasisseite 12 und einem damit verbindbaren Oberteil, umfassend eine Geräteanschlussseite 11, zwei Seitenteile 13, 13' und eine Erdungsschraube 17.

In der Nähe der Geräteanschlussseite 11 ist eine Leiterkarte 2 angeordnet und mit ihren Masseanschlüssen 24, 24', die in der Fig. 4 dargestellt sind, über Steckverbindungen variabler Einstecktiefe 4 mit der Geräteanschlussseite 11 elektrisch leitend verbunden. Diese Steckverbindungen 4 sind jeweils aus einem ersten Verbindungsteil 41 und einem zweiten Verbindungsteil 42 gebildet. Die Geräteanschlussseite 11 weist zylindrische Bohrungen auf, in denen die zweiten Verbindungsteile 42, die im vorliegenden Beispiel in Form von Spannstiften ausgeführt sind, kraftschlüssig fixiert sind. Die ersten Verbindungsteile 41 dagegen weisen basisseitig jeweils einen Gewindestift 411 auf. Mit diesen Gewindestiften 411 sind sie durch an den Masseanschlüssen 24 angeordneten Durchgangsöffnungen 25, 25' der Leiterkarte 2 geführt und jeweils in ein Stabilisierungselement 3 geschraubt. Diese Ausführung umfasst beispielhaft sechs Stabilisierungselemente 3, von denen aber in dieser Schnittdarstellung nur drei zu sehen sind. Die Stabilisierungselemente 3 sind jeweils aus mehreren miteinander verschraubten Schraubbolzen 31, 32, nämlich in diesem Fall aus einem langen Schraubbolzen 31 und einem kurzen Schraubbolzen 32, gebildet.

Die Gerätebasisseite 12 weist mehrere zylindrische Bohrungen mit je einem Innengewinde auf, die aber aus Übersichtlichkeitsgründen nicht mit einem Bezugszeichen versehen sind. In jede dieser Gewindebohrungen ist je einer der kurzen Schraubbolzen 32 mit seinem Gewindestift 321 eingeschraubt. Diese Gewindestifte 32 weisen an ihrem gegenüberliegenden Ende jeweils eine Gewindebohrung auf, in welche wiederum der lange Schraubbolzen 31 mit seinem Gewindestift 311 geschraubt ist, nachdem er zuvor durch eine Durchgangsöffnung einer weiteren Leiterkarte 22 geführt wurde. Die weitere Leiterkarte 22 kann, falls das Schaltungsdesign dies nahe legt, an zumindest einigen ihrer Durchgangsöffnungen auch Massekontakte aufweisen. Anderenfalls dient die Verschraubung am Stabilisierungselement lediglich ihrer mechanischen Fixierung.

Der Abstand der weiteren Leiterkarte 22 zur Gerätebasisseite 12 ist somit fest vorgegeben. Diese weitere Leiterkarte 22 ist aus thermischen Gründen sehr nahe an der Gerätebasisseite 12 angeordnet, beispielsweise in einem Abstand von 1 mm. Dazwischen verbleibt ein Zwischenraum 14, der beispielsweise zum Einfügen nicht in der Zeichnung dargestellter Wärmeleitelemente genutzt werden kann. Die weitere Leiterkarte 22 ist schließlich dafür vorgesehen, besonders leistungsintensive elektronische Bauteile aufzunehmen und kann durch ihre geometrische Nähe zur Gerätebasisseite 12 die entstehende Wärme insbesondere unter Verwendung der besagten, aus Übersichtlichkeitsgründen nicht in der Zeichnung dargestellten Wärmeleitelementen, sehr gut abführen.

Durch diese Vorgabe ist gemäß der vorliegenden Bauform auch der Abstand der in der Nähe der Geräteanschlussseite angeordneten Leiterkarte 2 zur Gerätebasisseite 12 festgelegt. Da die Abmessungen der weiteren Gehäusebauteile, in dieser schematischen Darstellung lediglich symbolisiert durch die Seitenteile 13, 13', von Gerät zu Gerät naturgemäß innerhalb bestimmter Toleranzbereiche variieren, ist die Steckverbindung variabler Einstecktiefe 4 in der beschriebenen Anordnung dazu geeignet, eine direkte Massekontaktierung der Leiterkarte 2 zur Geräteanschlussseite 11 zu ermöglichen. Auf diese Weise kann eine elektrische Störung schließlich auf dem nahezu kürzesten Weg zur Erdungsschraube 17 abgeleitet werden.

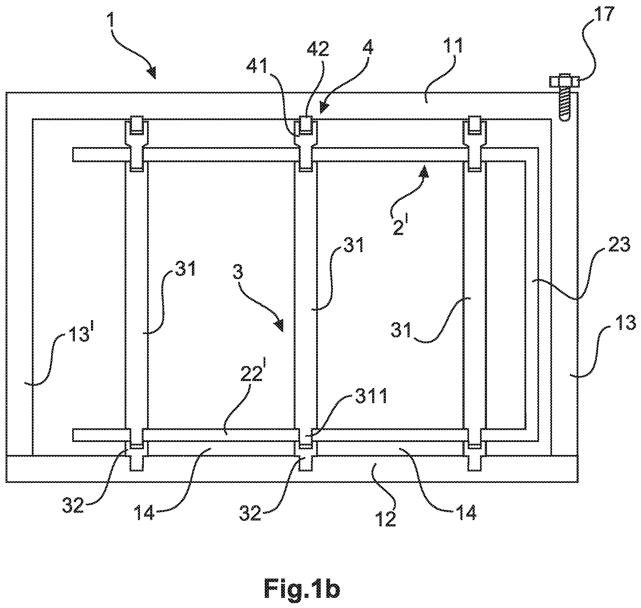

Die Fig. 1b unterscheidet sich von der vorangegangenen Darstellung lediglich dadurch, dass eine gefaltete Leiterkarte 2' verwendet wird. Die gefaltete Leiterkarte 2' zeichnet sich dadurch aus, dass sie einen gefalteten Bereich besitzt, der in diesem Fall durch den seitlichen 23 und den unteren 22' Teilbereich der Leiterkarte gebildet ist. Insbesondere ist dadurch der Abstand der Leiterkarte 2' zu der Gerätebasisseite 12 festgelegt, nämlich durch die Form des gefalteten Bereichs, umfassend zumindest den unteren Teilbereich 22', welcher funktional der weiteren Leiterkarte 22 aus der vorangegangenen Darstellung entspricht, und zusätzlich auch den seitlichen Teilbereich 23.

An dem seitlichen Teilbereich 23 kann z.B. ein Netzteil 27 angeordnet sein.

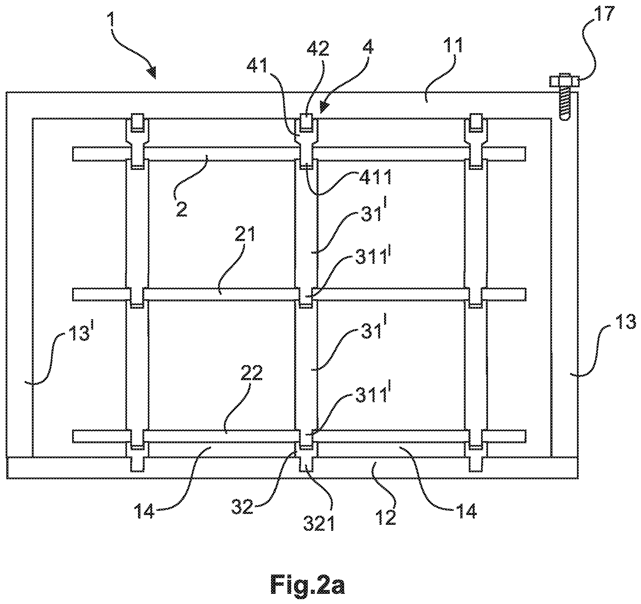

Die Fig. 2a zeigt eine Anordnung, bei der gegenüber der Anordnung aus Fig. 1a noch eine zusätzliche weitere Leiterkarte 21 hinzugekommen ist. Dementsprechend ist der lange Schraubbolzen 31 durch zwei mittlere Schraubbolzen 31' ersetzt, die mittels ihrer Gewindestifte 311' aneinander und, wie bereits beschrieben, gemeinsam an dem kurzen Gewindebolzen 32 verschraubt sind und dabei die weiteren Leiterkarten 21, 22 an deren Durchgangsöffnungen fixieren und gegebenenfalls an deren Masseanschlüsse elektrisch kontaktieren.

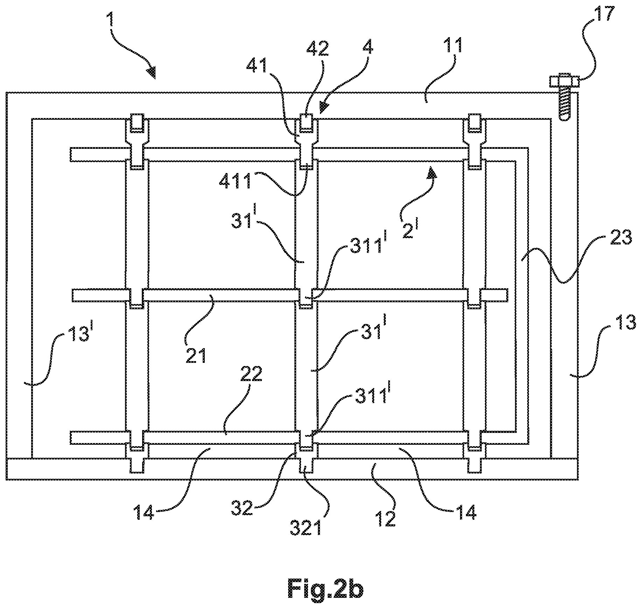

In der Fig. 2b ist eine Anordnung gezeigt, bei der die gefaltete Leiterkarte 2' mit der weiteren Leiterkarte 21 entsprechend kombiniert wird, so dass auch hier eine gestapelte Struktur entsteht, die funktional mit der zuvor beschriebenen Anordnung vergleichbar ist.

Die Fig. 3a und 3b stellen die Steckverbindung 4 in einer vergrößerten Ansicht dar. In zwei Phasen wird gezeigt, wie die beiden Verbindungsteile 41, 42 miteinander verbunden werden.

Die Fig. 3c und 3d stellen diesen Vorgang in einem Querschnitt durch die Verbindungskontakte 41, 42 dar.

Das erste Verbindungsteil 41 besitzt einen Steckbereich 414 mit einer im wesentlichen zylinderförmigen Ausnehmung, in welche das zweite Verbindungsteil 42, bei dem es sich in dieser Ausführung um einen in der Geräteanschlussseite 11 fixierten Spannstift handelt, kraftschlüssig aufgenommen wird. Das erste Verbindungsteil 41 besitzt zusätzlich zu seinem Steckbereich 414 auch einen Basisbereich 412 mit einem Gewindestift 411, der ein Außengewinde 413 aufweist, mit dem das erste Verbindungsteil 411 in eine nicht näher bezeichnete Gewindebohrung eines der Schraubbolzen 31 des Stabilisierungselements 3 eingeschraubt ist. Dadurch ist auch die Leiterkarte 2 an dem Stabilisierungselement 3 fixiert und mit ihrem Massekontakt 24 zumindest mit dem ersten Verbindungsteil 41 elektrisch kontaktiert und wird durch die Steckverbindung variabler Eistecktiefe 4 im gesteckten Zustand elektrisch leitend mit der Geräteanschlussseite 11 verbunden.

Die Fig. 3e und 3f zeigen in einer vergleichbaren Darstellung ein erstes Verbindungselement 41, das steckseitig in Steckrichtung verlaufende Schlitze aufweist, und somit als Tulpenstehbolzen ausgeführt ist. Dadurch weist in dieser Variante das erste Verbindungselement 41 senkrecht zur Steckrichtung eine elastische Verformbarkeit auf. Die Leiterplatte 2 ist in dieser Darstellung geschnitten dargestellt, so dass auch ein gewindefreier Abschnitt des Basisbereichs 412 des ersten Verbindungsteils 41 sichtbar ist.

Die Fig.4 zeigt die Leiterkarte 2 in einer Draufsicht. Dabei sind exemplarisch sechs Isolierkörper 28 einzelner Steckverbinder, im vorliegenden Fall handelt es sich um Rundsteckverbinder, z.B. M12-Steckverbinder, in die Leiterkarte 2 eingebaut. Weiterhin sind auch sechs Massekontakte 24, 24' mit symbolisch angedeuteten Masseverbindungen 26, 26' gezeigt, die in der Praxis einem hier nicht näher ausgeführten, individuellen Schaltungsdesign entsprechen können.

Weiterhin ist ein Stromanschluss 29 mit einem daran angeschlossenen Netzteil 27 auf der Leiterkarte angeordnet. Das Netzteil umfasst einen Gleichrichter 271 und einen elektrischen Filter 272, über den über eine Masseleitung 237 hochfrequente Störungen beispielhaft auf den Massekontakt 24 geleitet werden.

Innerhalb jedes Massekontaktes 24, 24' ist die besagte Durchgangsöffnung 25, 25' angeordnet, durch die das jeweilige erste Verbindungsteil 41 basisseitig verschraubt und gleichzeitig an dem Massekontakt 24, 24' kontaktiert werden kann.

Selbstverständlich können, je nach Schaltungsdesign, auch an anderen Stellen der Leiterkarte 2, 2' Störungen entstehen und über die entsprechenden Massekontakte 24' über vergleichsweise kurze Wege an die Erdungsschraube 17 abgeleitet werden.

Die Fig. 5a, 5b, 6a, 6b zeigen eine bezogen auf die Fig. 1b vergleichbare Anordnung in einer weniger schematischen und dafür praxisnäheren Ausführung. In den Darstellungen in Fig. 5a bis 6a ist dabei die Leiterkarte 2' aus Übersichtlichkeitsgründen entfernt. Das Stabilisierungselement 3, bestehend aus einem langen Schraubbolzen 31 und einem kurzen Schraubbolzen 32, ist dadurch in den Fig. 5a und 5b gut zu sehen.

Die Fig. 5a zeigt das Gehäuse 1 in einer schrägen Draufsicht. Das Gehäuse 1 besitzt ein Oberteil, umfassend die Geräteanschlussseite 11 und die beiden Seitenteile 13, 13'. Der Geräteanschlussseite 11 parallel gegenüberliegend ist die Gerätebasisseite 12 angeordnet, auf die das Oberteil aufgesetzt und daran befestigt ist. Eine nicht gezeigt anschraubbare Frontseite ist für diese Darstellung entfernt, um einen Blick in das Gehäuse 1 zu gestatten.

In der Geräteanschlussseite 11 sind eine Vielzahl von Einschraubhülsen 18 der Rundsteckverbinder angeordnet. In der hinten dargestellten Reihe sind die dazugehörigen, auf der Leiterkarte 2' angeordneten Isolierkörper 28 angedeutet, welche in die entsprechenden Einschraubhülsen 18 flexibel eintauchen und dadurch ebenfalls einen Toleranzausgleich des Gehäuses 1 ermöglichen.

In der Nähe der Erdungsschraube 17 ist der Stromanschluss 19 angeordnet.

Die Fig. 5b zeigt dieselbe Anordnung vergrößert aus einer etwas tieferen Perspektive. Insbesondere sind dabei auch die ersten Verbindungsteile 41 zu erkennen.

Die Fig. 6a zeigt die Anordnung im Querschnitt durch die Verbindungsteile 41, 42 und die Stabilisierungselemente 3 in Form der ineinander verschraubten Schraubbolzen 31, 32. In dieser Ausführungsform besitzt der kurze Schraubbolzen 32 zwei Gewindestifte 321, 321' und der Lange Schraubbolzen 31 besitzt zwei Gewindeausnehmungen 312, 312'.

Die Fig. 6b zeigt diese Anordnung mit der gefalteten Leiterkarte 2'. Bei dieser Anordnung ist das Netzteil 27 an dem seitlichen Teilbereich 23 aber in der Nähe der Erdungsschraube 17 und des in dieser Schnittdarstellung nicht sichtbaren Stromanschlusses 19 angeordnet.

Der Steckbereich 414 des ersten Verbindungsteils 41 ist hohlzylindrisch ausgeführt und bei dem zweiten Verbindungsteil 42 handelt es sich um einen Spannstift.

Diese Bauform ist weiterhin auch für die automatisierte Herstellung entsprechender elektrischer Geräte besonders vorteilhaft, weil durch das Zusammenbauen des Gerätes, also in diesem Fall das Aufsetzen des Gehäuseoberteils, umfassend die Geräteanschlussseite 11 und die Seitenteile 13, 13', auf die Gerätebasisseite 12, automatisch auch die Massekontaktierung der Leiterkarte 2' stattfindet, und zwar wie gewünscht in der vorteilhaften Form einer vermaschten Erdung mit einem gleichzeitigen durch die Steckverbindung variabler Einstecktiefe 4 ermöglichten Ausgleich der Gehäusetoleranzen.

### Bezugszeichenliste

- 1: Gehäuse
- 11: Geräteanschlussseite
- 12: Gerätebasisseite
- 13, 13': Seitenteile
- 14: Raum für (nicht dargestellte) Thermoleitelemente
- 17: Erdungsschraube
- 18: (Einschraub-)Hülsen einzelner Steckverbinder
- 19: Stromanschluss

- 2, 2': Leiterkarte, gefaltete Leiterkarte
- 21, 21',22: weitere Leiterkarten,
- 22': gefalteter Bereich / unterer Teilbereich der gefalteten Leiterkarte
- 23: seitlicher Teilbereich der gefalteten Leiterkarte
- 24, 24': Massekontakt
- 25, 25': Durchgangsöffnung
- 26, 26': Masseverbindung
- 27: Schaltnetzteil
- 271: Schaltnetzteil / Gleichrichter
- 272: Elektronischer Filter
- 273: Masseleitung / Masseleiterbahn
- 28: Isolierkörper einzelner Steckverbinder (z.B. M12)
- 29: Stromanschluss

- 3: Stabilisierungselement
- 31: langer Schraubbolzen
- 31': mittlerer Schraubbolzen
- 32: kurzer Schraubbolzen
- 311, 311', 321: Gewindestifte der Schraubbolzen

- 4: Steckverbindung variabler Einstecktiefe
- 41: erstes Verbindungsteil
- 411: Gewindestift des ersten Verbindungsteils
- 412: Basisbereich des ersten Verbindungsteils
- 413: Gewinde des ersten Verbindungsteils
- 414: Steckbereich des ersten Verbindungsteils
- 42, 42': zweites Verbindungsteil

## Patentansprüche

1. Anordnung zur Masseanbindung einer Leiterkarte (2, 2') an ein Gehäuse (1) eines elektrischen Gerätes, umfassend das Gehäuse (1), das zumindest teilweise aus einem elektrisch leitfähigen Material besteht, die Leiterkarte (2, 2'), die zumindest einen Massekontakt (24, 24') aufweist, und mindestens eine Masseverbindung zur elektrisch leitenden Verbindung des mindestens einen Massekontaktes der Leiterkarte mit dem Gehäuse, wobei die mindestens eine Masseverbindung jeweils durch eine Steckverbindung variabler Einstecktiefe (4) gebildet ist, wobei die Steckverbindung (4) ein erstes Verbindungsteil (41) und ein zweites Verbindungsteil (42) umfasst, die zur gegenseitigen elektrischen Kontaktierung kraftschlüssig, aber innerhalb eines vorgegebenen Bereichs verschiebbar miteinander verbindbar sind, wobei das erste Verbindungsteil (41) an einem Ende einen Basisbereich (412) und gegenüberliegend einen Steckbereich (414) besitzt, wobei der Basisbereich (412) an dem mindestens einen Massekontakt (24, 24') der Leiterkarte (2, 2') angeordnet und elektrisch leitend damit verbunden ist,
wobei die Leiterkarte (2, 2') an ihrem mindestens einen Massekontakt (24, 24') eine Durchgangsöffnung (25, 25') aufweist, durch welche das erste Verbindungsteil (41) basisseitig an einem Stabilisierungselement (3) mechanisch fixierbar, insbesondere verschraubbar, ist, **dadurch gekennzeichnet, dass**
es sich bei dem Stabilisierungselement (3) um mehrere miteinander verschraubte Schraubbolzen (31, 31', 32) handelt und dass mindestens zwei dieser Schraubbolzen (31, 31', 32) miteinander durch mindestens eine weitere Durchgangsöffnung eines gefalteten Bereichs der Leiterkarte (22') und/oder mindestens einer weiteren Leiterkarte (22) verschraubt sind, um den gefalteten Bereich (22') und/oder die weitere Leiterkarte (22) mechanisch zu fixieren.

2. Anordnung gemäß Anspruch 1, **dadurch gekennzeichnet, dass** der gefaltete Bereich der Leiterkarte (22') und/oder die mindestens eine weitere Leiterkarte (22) an zumindest einer der besagten weiteren Durchgangsöffnungen einen weiteren Massekontakt aufweist, um zusätzlich zur mechanischen Fixierung auch eine weitere Massekontaktierung über das Stabilisierungselement (3) und die Steckverbindung (4) zu besitzen.

3. Anordnung gemäß einem der Ansprüche 1 bis 2, **dadurch gekennzeichnet, dass** das Stabilisierungselement (3) an einer Gerätebasisseite (12) des Gehäuses (1) befestigt ist und dass das zweite Verbindungsteil (42) an einer Geräteanschlussseite (11) des Gehäuses (1) elektrisch leitend befestigt ist, wobei die Geräteanschlussseite (11) der Gerätebasisseite (12) parallel gegenübersteht.

4. Anordnung gemäß Anspruch 3, **dadurch gekennzeichnet, dass** das Gehäuse (1) zur Befestigung jedes Stabilisierungselements (3) und jedes zweiten Verbindungsteils (42) in der Gerätebasisseite (12) und in der Geräteanschlussseite (11) jeweils eine zylinderförmige Ausnehmung aufweist, und dass zumindest diejenigen Ausnehmungen, die in der Gerätebasisseite (12) angeordnet sind, jeweils ein Innengewinde aufweisen, um einen Gewindestift (321) des jeweiligen Stabilisierungselements (3) darin einzuschrauben.

5. Anordnung nach einem der vorstehenden Ansprüche, **dadurch gekennzeichnet, dass** zumindest eines der beiden Verbindungselemente (41, 42) zumindest steckseitig elastisch verformbar ist.

6. Anordnung nach Anspruch 5, **dadurch gekennzeichnet, dass** es sich bei einem der beiden Verbindungselemente (41, 42) um einen Tulpenstehbolzen handelt und/oder dass es sich bei einem der beiden Verbindungselemente (41, 42) um einen Spannstift oder eine Spannhülse handelt.

7. Verfahren zur Masseanbindung einer Leiterkarte (2, 2') an ein zumindest teilweise elektrisch leitfähiges Gehäuse mittels einer Anordnung gemäß dem unabhängen Anspruch 1, **gekennzeichnet durch** folgende Schritte:
a.) Befestigen des mindestens einen Stabilisierungselements (3) mit seinem ersten Ende an einer Gerätebasisseite (12) des Gehäuses (1);
b.) mechanisches Verbinden des mindestens einen Stabilisierungselementes (3) an seinem zweiten Ende mit der Leiterkarte (2, 2');
c.) Befestigen des mindestens einen ersten Verbindungsteils (41) an dem mindestens einen Stabilisierungselement (3) unter gleichzeitiger Fixierung der Leiterkarte (2, 2') zwischen dem mindestens einen ersten Verbindungsteil (41) und dem mindestens einen Stabilisierungselement (3) bei gleichzeitiger elektrischer Kontaktierung des mindestens einen Massekontakts (24, 24') der Leiterkarte (2, 2') durch das mindestens eine erste Verbindungsteil (41);
d.) Befestigen des mindestens einen zweiten Verbindungsteils (42) an einer Geräteanschlussseite (11) des Gehäuses (1);
e.) mechanisches Zusammenbauen des Gehäuses (1) und gleichzeitiges automatisches elektrisch leitendes Verbinden des Gehäuses mit dem mindestens einen Massekontakt (24, 24') der Leiterkarte (2, 2') über die mindestens eine Steckverbindung variabler Einstecktiefe (4), umfassend das mindestens eine erste (41) und das mindestens eine zweite (42) Verbindungsteil, bei gleichzeitigem mechanischen Ausgleich innerhalb eines vorgegebenen Toleranzbereichs abweichender Gehäuseabmessungen durch eine entsprechende Anpassung der Einstecktiefe der Steckverbindung (4) zwischen dem mindestens einen ersten (41) und dem mindestens einen zweiten (42) Verbindungsteil.

8. Verfahren gemäß Anspruch 7, wobei in Verfahrensschritt a.) das Befestigen des Stabilisierungselements (3) an der Gerätebasisseite (12) durch ein Einschrauben eines Gewindestifts (321) des Stabilisierungselements (3) in eine Gewindebohrung der Gerätebasisseite (12) erfolgt, wobei das Stabilisierungselement (3) durch ein Zusammenschrauben mehrerer Schraubbolzen (31, 31', 32) hergestellt wird.

9. Verfahren gemäß Anspruch 8, **dadurch gekennzeichnet, dass** beim Zusammenschrauben der mehreren Schraubbolzen (31, 31', 32) jeweils ein Schraubbolzen (31, 31', 32) mit seinem Gewindestift durch mindestens eine Durchgangsöffnung, die in einem gefalteten Bereichs der Leiterkarte (22') und/oder in mindestens einer weiteren Leiterkarte (22) angeordnet ist, geführt und mit einer Gewindebohrung eines weiteren Schraubbolzens (31', 32) verschraubt wird, wodurch auch der gefaltete Bereich der Leiterkarte (22') und/oder die mindestens eine weitere Leiterkarte (22) zwischen diesen beiden Schraubbolzen (31', 32) an dem Stabilisierungselement (3) und so relativ zur Gerätebasisseite (12) mechanisch fixiert wird.

10. Verfahren gemäß Anspruch 9, **dadurch gekennzeichnet, dass** beim Zusammenschrauben der mehreren Schraubbolzen (31, 31', 32) zumindest eines Stabilisierungselements (3) zumindest einer der Schraubbolzen (31, 31', 32) mechanisch und elektrisch leitend mit zumindest einem weiteren Massekontakt verbunden wird, der in dem gefalteten Bereichs der Leiterkarte (22') und/oder in der mindestens einen weiteren Leiterkarte (22) an der dazugehörigen Durchgangsöffnung angeordnet ist.

## Claims

1. Arrangement for the ground connection of a printed circuit board (2, 2') to a frame (1) of an electrical device, comprising the frame (1), which consists at least partially of an electrically conductive material, the printed circuit board (2, 2'), which has at least one ground contact (24, 24'), and at least one ground connection for the electrically conductive connection of the at least one ground contact of the printed circuit board to the frame, wherein the at least one ground connection is formed in each case by a plug connection having a variable insertion depth (4), wherein the plug connection (4) comprises a first connecting part (41) and a second connecting part (42), which can be connected to one another with force fit, but such that they are displaceable within a predetermined range, for mutual electrical contacting, wherein the first connecting part (41) possesses a base area (412) at one end and, opposite, a plug area (414), wherein the base area (412) is arranged on the at least one ground contact (24, 24') of the printed circuit board (2, 2') and electrically conductively connected thereto,
wherein the printed circuit board (2, 2') has a through-opening (25, 25') at its at least one ground contact (24, 24'), through which the first connecting part (41) can be mechanically fastened, in particular screwed, to a stabilizing element (3) on the base side, **characterized in that** the stabilizing element (3) is a plurality of screwed-together screw bolts (31, 31', 32) and **in that** at least two of these screw bolts (31, 31', 32) are screwed together through at least one further through-opening of a folded area of the printed circuit board (22') and/or at least one further printed circuit board (22) in order to mechanically fasten the folded area (22') and/or the further printed circuit board (22).

2. Arrangement according to Claim 1, **characterized in that** the folded area of the printed circuit board (22') and/or the at least one further printed circuit board (22) has a further ground contact at at least one of the said further through-openings so that it also possesses further ground contacting via the stabilizing element (3) and the plug connection (4) in addition to the mechanical fastening.

3. Arrangement according to either of Claims 1 and 2, **characterized in that** the stabilizing element (3) is secured to a device base side (12) of the frame (1) and **in that** the second connecting part (42) is electrically conductively secured to a device connection side (11) of the frame (1), wherein the device connection side (11) is parallel to and opposite the device base side (12).

4. Arrangement according to Claim 3, **characterized in that** the frame (1) has a respective cylindrical recess for securing each stabilizing element (3) and each second connecting part (42) in the device base side (12) and in the device connection side (11), and **in that** at least those recesses which are arranged in the device base side (12) each have an internal thread in order to screw a threaded pin (321) of the respective stabilizing element (3) therein.

5. Arrangement according to one of the preceding claims, **characterized in that** at least one of the two connecting elements (41, 42) is elastically deformable at least on the plug side.

6. Arrangement according to Claim 5, **characterized in that** one of the two connecting elements (41, 42) is a tulip-head bolt and/or **in that** one of the two connecting elements (41, 42) is a clamping pin or a clamping sleeve.

7. Method for the ground connection of a printed circuit board (2, 2') to an at least partially electrically conductive frame by means of an arrangement according to independent Claim 1, **characterized by** the following steps:
a.) securing the at least one stabilizing element (3) by its first end to a device base side (12) of the frame (1);
b.) mechanically connecting the at least one stabilizing element (3) at its second end to the printed circuit board (2, 2');
c.) securing the at least one first connecting part (41) to the at least one stabilizing element (3) with simultaneous fastening of the printed circuit board (2, 2') between the at least one connecting part (41) and the at least one stabilizing element (3), while simultaneously establishing electrical contact between at least one ground contact (24, 24') of the printed circuit board (2, 2') and the at least one first connecting part (41);
d.) securing the at least one second connecting part (42) to a device connection side (11) of the frame (1);
e.) mechanically assembling the frame (1) and simultaneously automatically electrically conductively connecting the frame to the at least one ground contact (24, 24') of the printed circuit board (2, 2') via the at least one plug connection having a variable insertion depth (4), comprising the at least one first (41) and the at least one second (42) connecting part, while simultaneously mechanically compensating deviating frame dimensions within a predetermined tolerance range by correspondingly adapting the insertion depth of the plug connection (4) between the at least one first (41) and the at least one second (42) connecting part.

8. Method according to Claim 7, wherein, in method step a.), the securing of the stabilizing element (3) to the device base side (12) takes place by screwing a threaded pin (321) of the stabilizing element (3) into a threaded bore of the device base side (12), wherein the stabilizing element (3) is produced by screwing a plurality of screw bolts (31, 31', 32) together.

9. Method according to Claim 8, **characterized in that,** when screwing the plurality of screw bolts (31, 31', 32) together, in each case one screw bolt (31, 31', 32) is guided by its threaded pin through at least one through-opening, which is arranged in a folded area of the printed circuit board (22') and/or in at least one further printed circuit board (22), and is screwed to a threaded bore of a further screw bolt (31', 32), whereby the folded area of the printed circuit board (22') and/or the at least one further printed circuit board (22) is also mechanically fastened between these two screw bolts (31', 32) on the stabilizing element (3) and therefore relative to the device base side (12).

10. Method according to Claim 9, **characterized in that,** when screwing the plurality of screw bolts (31, 31', 32) of least one stabilizing element (3) together, at least one of the screw bolts (31, 31', 32) is mechanically and electrically conductively connected to at least one further ground contact, which is arranged in the folded area of the printed circuit board (22'), and/or in the at least one further printed circuit board (22), at the associated through-opening.

## Revendications

1. Arrangement de connexion à la masse d'un circuit imprimé (2, 2') à un boîtier (1) d'un appareil électrique, comprenant le boîtier (1), qui se compose au moins partiellement d'un matériau électriquement conducteur, le circuit imprimé (2, 2'), qui possède au moins un contact de masse (24, 24'), et au moins une liaison de masse destinée à relier de manière électriquement conductrice l'au moins une liaison de masse du circuit imprimé avec le boîtier, l'au moins une liaison de masse étant respectivement formée par une liaison par enfichage à profondeur d'enfichage (4) variable, la liaison par enfichage (4) comportant une première pièce de liaison (41) et une deuxième pièce de liaison (42) qui peuvent être reliées ensemble par assemblage de force, mais de manière coulissante à l'intérieur d'une zone prédéfinie, en vue de l'établissement d'un contact électrique mutuel, la première pièce de liaison (41) possédant à une extrémité une zone de base (412) et, en vis-à-vis, une zone d'enfichage (414), la zone de base (412) étant disposée au niveau de l'au moins un contact de masse (24, 24') du circuit imprimé (2, 2') et étant reliée de manière électriquement conductrice à celui-ci,
le circuit imprimé (2, 2') possédant au niveau de son au moins un contact de masse (24, 24') une ouverture de passage (25, 25') à travers laquelle la première pièce de liaison (41) peut être calée mécaniquement, notamment vissée, du côté de la base à un élément de stabilisation (3), **caractérisé en ce que** l'élément de stabilisation (3) est réalisé sous la forme de plusieurs boulons filetés (31, 31', 32) et **en ce qu'**au moins deux de ces boulons filetés (31, 31', 32) sont vissés l'un à l'autre à travers au moins une ouverture de passage supplémentaire d'une zone pliée du circuit imprimé (22') et/ou d'au moins un circuit imprimé supplémentaire (22) afin de caler mécaniquement la zone pliée (22') et/ou le circuit imprimé supplémentaire (22).

2. Arrangement selon la revendication 1, **caractérisé en ce que** la zone pliée du circuit imprimé (22') et/ou l'au moins un circuit imprimé supplémentaire (22) possède au niveau d'au moins l'une desdites ouvertures de passage supplémentaires un contact de masse supplémentaire afin de posséder, en plus du calage mécanique, également une mise en contact à la masse par le biais de l'élément de stabilisation (3) et de la liaison par enfichage (4).

3. Arrangement selon l'une des revendications 1 à 2, **caractérisé en ce que** l'élément de stabilisation (3) est fixé à un côté de base d'appareil (12) du boîtier (1) et **en ce que** la deuxième pièce de liaison (42) est fixée de manière électriquement conductrice à un côté de raccordement d'appareil (11) du boîtier (1), le côté de raccordement d'appareil (11) faisant face en parallèle au côté de base d'appareil (12).

4. Arrangement selon la revendication 3, **caractérisé en ce que** pour la fixation de chaque élément de stabilisation (3) et de chaque deuxième pièce de liaison (42), le boîtier (1) possède respectivement dans le côté de base d'appareil (12) et dans le côté de raccordement d'appareil (11) une cavité de forme cylindrique, et **en ce qu'**au moins les cavités qui sont disposées dans le côté de base d'appareil (12) possèdent respectivement un filetage femelle en vue de visser dans celui-ci une broche filetée (321) de l'élément de stabilisation (3) respectif.

5. Arrangement selon l'une des revendications précédentes, **caractérisé en ce qu'**au moins l'un des deux éléments de liaison (41, 42) est déformable élastiquement au moins du côté de l'enfichage.

6. Arrangement selon la revendication 5, **caractérisé en ce que** l'un des deux éléments de liaison (41, 42) est un boulon d'entretoisement en tulipe et/ou **en ce que** l'un des deux éléments de liaison (41, 42) est une broche de serrage ou une douille de serrage.

7. Procédé de connexion à la masse d'un circuit imprimé (2, 2') à un boîtier au moins partiellement électriquement conducteur au moyen d'un arrangement selon la revendication indépendante 1, **caractérisé par** les étapes suivantes :
a) fixation de l'au moins un élément de stabilisation (3) par sa première extrémité à un côté de base d'appareil (12) du boîtier (1) ;
b) liaison mécanique de l'au moins un élément de stabilisation (3) au niveau de sa deuxième extrémité avec le circuit imprimé (2, 2') ;
c) fixation de l'au moins une première pièce de liaison (41) à l'au moins un élément de stabilisation (3) en fixant simultanément le circuit imprimé (2, 2') entre l'au moins une première pièce de liaison (41) et l'au moins un élément de stabilisation (3) en établissant simultanément le contact électrique avec l'au moins un contact de masse (24, 24') du circuit imprimé (2, 2') par le biais de l'au moins une première pièce de liaison (41) ;
d) fixation de l'au moins une deuxième pièce de liaison (42) à un côté de raccordement d'appareil (11) du boîtier (1) ;
e) assemblage mécanique du boîtier (1) et, simultanément, liaison électriquement conductrice automatique du boîtier avec l'au moins un contact de masse (24, 24') du circuit imprimé (2, 2') par le biais de l'au moins une liaison par enfichage à profondeur d'enfichage (4) variable, comprenant l'au moins une première (41) et l'au moins une deuxième pièce de liaison (42), avec compensation mécanique simultanée à l'intérieur d'une plage de tolérances prédéfinie de dimensions de boîtier divergentes par une adaptation en conséquence de la profondeur d'enfichage de la liaison par enfichage (4) entre l'au moins une première (41) et l'au moins une deuxième pièce de liaison (42).

8. Procédé selon la revendication 7, la fixation de l'élément de stabilisation (3) au côté de base d'appareil (12) à l'étape a) étant effectuée par un vissage d'une broche filetée (321) de l'élément de stabilisation (3) dans un trou fileté du côté de base d'appareil (12), l'élément de stabilisation (3) étant fabriqué par un vissage de plusieurs boulons filetés (31, 31', 32) entre eux.

9. Procédé selon la revendication 8, **caractérisé en ce que** lors du vissage des plusieurs boulons filetés (31, 31', 32) entre eux, un boulon fileté (31, 31', 32) est respectivement passé avec sa broche filetée à travers au moins une ouverture de passage qui est disposée dans une zone pliée du circuit imprimé (22') et/ou dans au moins un circuit imprimé supplémentaire (22), puis vissé avec un boulon fileté (31', 32) supplémentaire, moyennant quoi la zone pliée du circuit imprimé (22') et/ou l'au moins un circuit imprimé supplémentaire (22) est calé mécaniquement entre ces deux boulons filetés (31', 32) au niveau de l'élément de stabilisation (3) et ainsi par rapport au côté de base d'appareil (12).

10. Procédé selon la revendication 9, **caractérisé en ce que** lors du vissage des plusieurs boulons filetés (31, 31', 32) entre eux, au moins un élément de stabilisation (3) d'au moins l'un des boulons filetés (31, 31', 32) est relié mécaniquement et de manière électriquement conductrice avec au moins un contact de masse supplémentaire qui est disposé dans la zone pliée du circuit imprimé (22') et/ou dans l'au moins un circuit imprimé supplémentaire (22) au niveau de l'ouverture de passage associée.
